# EUROPEAN PATENT SPECIFICATION

(11) **EP 2 886 339 B1**
(45) Date of publication and mention of the grant of the patent: **01.03.2017**
(21) Application number: 13879505.9
(22) Date of filing: 13.08.2013
(51) Int. Cl.: B32B 27/34, B32B 15/088, C08G 59/20, C08G 59/42, C08G 59/68, C08K 3/22, C08L 63/00, C08L 79/08, H05K 1/03

(54) **RESIN SHEET, SUPPORT BODY WITH RESIN LAYER, LAMINATE PLATE, AND METAL-CLAD LAMINATE PLATE**
HARZFOLIE, TRÄGERKÖRPER MIT EINER HARZSCHICHT, LAMINATPLATTE UND METALLKASCHIERTE LAMINATPLATTE
FEUILLE DE RÉSINE, CORPS DE SUPPORT COMPRENANT UNE COUCHE DE RÉSINE, PLAQUE STRATIFIÉE, ET PLAQUE STRATIFIÉE REVÊTUE DE MÉTAL

(30) Priority: 16.08.2012 JP 2012180496
(43) Date of publication of application: 24.06.2015
(73) Proprietor: Mitsubishi Gas Chemical Company, Inc., Tokyo 100-8324 (JP)
(72) Inventor: TAKADA, Keisuke, Tokyo 125-8601 (JP); HIRANO, Syunsuke, Tokyo 125-8601 (JP); MORISHITA, Koji, Nishi-Shirakawa-gun Fukushima 961-8031 (JP); KAWAI, Hidetoshi, Tokyo 125-8601 (JP); KOGA, Yuichi, Nishi-Shirakawa-gun Fukushima 961-8031 (JP); KATO, Yoshihiro, Tokyo 100-8324 (JP)
(74) Representative: Hoffmann Eitle
(86) International application number: PCT/JP2013/071856
(87) International publication number: WO 2014/027654

(56) References cited:
- EP-A2- 0 913 429
- JP-A- H08 041 168
- JP-A- 2008 297 536
- JP-A- 2011 035 110
- JP-A- 2011 093 966
- US-B1- 6 297 341

## Description

### Technical Field

The present invention relates to a resin sheet, a support with a resin layer, a laminate and a metal foil-clad laminate.

### Background Art

Conventionally, as an LED-mounting printed-wiring board, for example, a white substrate in which titanium dioxide is dispersed in an epoxy resin has been known (see, for example, Patent Document 1). Furthermore, LEDs emitting short-wavelength light such as a blue color or a white color have been generalized, and thus a white substrate for use in a printed-wiring board, which is excellent in heat resistance and light resistance, has been particularly demanded. In order to respond to such a demand, a white substrate has also been developed in which the reduction in reflectance during irradiation with short-wavelength light is suppressed (see, for example, Patent Document 2).

### Citation List

### Patent Documents

- Patent Document 1:: Japanese Patent Application Laid-Open No. 10-202789
- Patent Document 2:: Japanese Patent Application Laid-Open No. 2008-1880

### Summary of Invention

### Technical Problem

In the white substrate described in Patent Document 1, however, the surface of the substrate is discolored to cause a remarkable reduction in reflectance due to a heating treatment in a production step of a printed-wiring board and an LED-mounting step, and due to heating or light irradiation in use after LED-mounting.

In recent years, LEDs have been demanded to have further higher luminance and higher output. Additionally, the application field of LEDs extends from conventional small display applications such as mobile phones and car navigation to large display applications such as televisions and also residential illumination applications. The white substrate described in Patent Document 2, however, cannot be said to have sufficient discoloration resistance and deterioration resistance against heat and light required for such demands and applications, and is difficult to suppress the reduction in light reflectance.

The present invention has been made under the circumstances, and an object thereof is to provide a resin sheet, a support with a resin layer, a laminate and a metal foil-clad laminate that exhibit a small reduction in light reflectance due to a heating treatment and a light irradiation treatment with an excellent heat resistance being maintained.

### Solution to Problem

The present inventors have made intensive studies in order to achieve the object, and as a result, have found that a support is impregnated with a resin composition including an aliphatic epoxy-modified silicone compound, a branched imide resin having an isocyanurate group and a carboxyl group, titanium dioxide and a wetting and dispersing agent to thereby provide a resin sheet and the like that exhibit a small reduction in light reflectance due to a heating treatment and a light irradiation treatment with an excellent heat resistance being maintained, leading to the present invention.

That is, the present invention provides the following <1> to <18>.
<1> A resin sheet comprising a layer including a resin composition containing an aliphatic epoxy-modified silicone compound (A), a branched imide resin having an isocyanurate group and a carboxyl group (B), titanium dioxide (C) and a wetting and dispersing agent (D).
<2> The resin sheet according to the above <1 >, wherein the branched imide resin (B) comprises a modified branched imide resin obtained by reacting one or more compounds selected from the group consisting of an epoxy compound, an alcohol compound and an amine compound with a branched imide resin having an isocyanurate group and a carboxyl group.
<3> The resin sheet according to the above <1 > or <2>, wherein an acid value of the branched imide resin (B) is 10 to 200 mgKOH/g.
<4> The resin sheet according to any one of the above <1> to <3>, wherein an acid value of the wetting and dispersing agent (D) is 20 to 200 mgKOH/g.
<5> The resin sheet according to any one of the above <1> to <4>, wherein the resin composition further contains a phosphorus curing accelerator (E).
<6> The white insulating resin sheet according to the above <5>, wherein a content of the phosphorus curing accelerator (E) contained in the resin composition is 0.1 to 10 parts by mass based on 100 parts by mass of the total of the aliphatic epoxy-modified silicone compound (A) and the branched imide resin (B).
<7> The resin sheet according to any one of the above <1> to <6>, wherein the resin composition further contains an epoxy monomer having one or more epoxy rings (F) other than the aliphatic epoxy-modified silicone compound (A).
<8> The white insulating resin sheet according to the above <7>, wherein a content of the epoxy monomer (F) contained in the resin composition is 0.5 to 10 parts by mass based on 100 parts by mass of the total of the aliphatic epoxy-modified silicone compound (A) and the branched imide resin (B).
<9> The resin sheet according to any one of the above <1> to <8>, wherein a content of the aliphatic epoxy-modified silicone compound (A) contained in the resin composition is 20 to 80 parts by mass based on 100 parts by mass of the total of the aliphatic epoxy-modified silicone compound (A) and the branched imide resin (B).
<10> The resin sheet according to any one of the above <1> to <9>, wherein a content of the titanium dioxide (C) contained in the resin composition is 10 to 300 parts by mass based on 100 parts by mass of the total of the aliphatic epoxy-modified silicone compound (A) and the branched imide resin (B).
<11> The resin sheet according to any one of the above <1> to <10>, wherein the titanium dioxide (C) is subjected to a surface treatment with one or more oxides selected from the group consisting of SiO₂, Al₂O₃, ZrO₂ and ZnO, and contains 0.5 to 15 parts by mass of the oxides based on 100 parts by mass of the total amount of the titanium dioxide subjected to the surface treatment.
<12> The resin sheet according to any one of the above <1> to <11>, wherein a content of the wetting and dispersing agent (D) contained in the resin composition is 0.05 to 10 parts by mass based on 100 parts by mass of the total of the aliphatic epoxy-modified silicone compound (A) and the branched imide resin (B).
<13> The resin sheet according to any one of the above <1> to <12>, wherein the resin sheet is an insulating resin sheet.
<14> The resin sheet according to any one of the above <1> to <13>, wherein the resin sheet is a white resin sheet.
<15> A support with a resin layer, comprising a support and the resin sheet according to any one of the above <1> to <14> provided on the support.
<16> The support with a resin layer according to the above <15>, wherein the support is one or more selected from the group consisting of a film containing one or more resins selected from the group consisting of polyvinyl chloride, polyvinylidene chloride, polybutene, polybutadiene, polyurethane, an ethylene-vinyl acetate copolymer, polyethylene terephthalate, polyethylene, polypropylene, an ethylene-propylene copolymer, polymethylpentene and polybutylene terephthalate, aluminum foil, and copper foil.
<17> A laminate comprising the resin sheet according to any one of the above <1 > to <14> and a metal layer or a resin layer provided on the resin sheet.
<18> A metal foil-clad laminate comprising the resin sheet according to any one of the above <1> to <14> and metal foil provided on the resin sheet.

### Advantageous Effects of Invention

The present invention can provide a resin sheet, a support with a resin layer, a laminate and a metal foil-clad laminate that exhibit a small reduction in light reflectance due to a heating treatment and a light irradiation treatment with an excellent heat resistance being maintained.

### Description of Embodiments

Hereinafter, an embodiment for carrying out the present invention (hereinafter, simply referred to as "the present embodiment") is described. It is to be noted that the following present embodiment is illustrative for explaining the present invention and the present invention is not limited to only the present embodiment. The present invention can be variously modified without departing the gist thereof.

The present embodiment relates to a resin sheet including a layer including a resin composition containing an aliphatic epoxy-modified silicone compound (A) (hereinafter, simply also referred to as "component (A)"), a branched imide resin having an isocyanurate group and a carboxyl group (B) (hereinafter, simply also referred to as "component (B)"), titanium dioxide (C) and a wetting and dispersing agent (D). The resin sheet is preferably a sheet having insulation property, preferably a white resin sheet, further preferably a white insulating resin sheet, from the viewpoint of being useful for use in the substrate of an LED-mounting printed-wiring board.

The resin sheet of the present embodiment may also be a resin sheet in which the resin composition further contains a phosphorus curing accelerator (E).

The resin sheet of the present embodiment may also be a resin sheet in which the resin composition further contains an epoxy monomer (F) having one or more epoxy rings (hereinafter, simply referred to as "component (F)") other than the component (A).

A support with a resin layer of the present embodiment is one including a support and the resin sheet provided on the support.

A laminate of the present embodiment is a laminate including the resin sheet and a metal layer or a resin layer provided on the resin sheet.

Furthermore, a metal foil-clad laminate of the present embodiment is a metal foil-clad laminate including the resin sheet and metal foil provided on the resin sheet.

The aliphatic epoxy-modified silicone compound (A) contained in the resin composition for use in the present embodiment is a silicone compound having a siloxane bond (Si-O-Si bond) in the main skeleton, into which a substituted or unsubstituted aliphatic hydrocarbon group having an epoxy group is introduced. Such an aliphatic epoxy-modified silicone compound (A) is used together with the branched imide resin (B), the titanium dioxide (C) and the wetting and dispersing agent (D) to result in the increase in light reflectance of the resin sheet in an ultraviolet region and in a visible light region, suppressing the reduction in light reflectance due to a heating treatment and a light irradiation treatment. Additionally, such a resin sheet tends to be significantly improved in peel strength from the metal foil and heat resistance.

The aliphatic epoxy-modified silicone compound (A) is preferably a silicone compound having a repeating unit represented by the following formula (1), having at least three R'(s) in one molecule, and not containing an alkoxy group. In particular, a liquid compound is preferable because of being excellent in workability. The phrase "having a repeating unit represented by the following formula (1)" here means to encompass both cases, not only a case of "having a plurality of one certain kind of repeating units in which R and/or R' is the same but also a case of "having a plurality of kinds of repeating units in which R and/or R' is different. Even in both of the case of having a plurality of one certain kind of repeating units in which R and/or R' is the same and the case of having a plurality of kinds of units in which R and/or R' is different, it is preferable to have three or more repeating units. 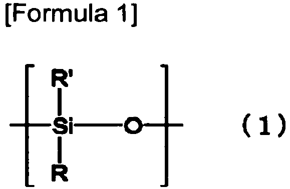 wherein R represents a hydrogen atom, or a substituted or unsubstituted monovalent hydrocarbon group, and R' represents a monovalent organic group having an epoxy group.

In the formula (1), examples of the monovalent hydrocarbon group represented by R include a substituted or unsubstituted aliphatic hydrocarbon group, and the number of carbon atoms thereof is preferably 1 to 20, more preferably 1 to 8. More specifically, examples include alkyl groups such as a methyl group, an ethyl group, a propyl group, a butyl group, a hexyl group and an octyl group, and a group in which hydrogen atoms in such a monovalent hydrocarbon group are partially or entirely substituted with one or more groups among an epoxy group (however, excluding an epoxycyclohexyl group), a methacryl group, an acryl group, a mercapto group and an amino group. Among them, R preferably represents one or more among a methyl group, an ethyl group and a hydrogen atom, more preferably a methyl group, from the viewpoint that the effect of the present invention is more effectively and certainly exerted. The monovalent hydrocarbon group, however, is not limited to the above.

Examples of the monovalent organic group having an epoxy group represented by R' in the formula (1) include a substituted or unsubstituted aliphatic hydrocarbon group having an epoxy group, and the number of carbon atoms thereof is preferably 2 to 20, more preferably 2 to 12. In particular, R' is preferably a monovalent organic group having a 3,4-epoxycyclohexyl group from the viewpoint that cure shrinkage is small. More specifically, the monovalent organic group having an epoxy group includes one or more of a glycidoxypropyl group and a 3,4-epoxycyclohexylethyl group. The monovalent organic group having an epoxy group, however, is not limited to the above.

Herein, the silicone compound having the repeating unit represented by the formula (1) preferably has 3 to 8 of R'(s) in one molecule. When the silicone compound having the repeating unit represented by the formula (1) has R'(s) in this range, a cured product higher in hardness and also more excellent in toughness tends to be easily obtained.

The silicone compound having the repeating unit represented by the formula (1) preferably has a degree of polymerization of 3 to 100. One having the degree of polymerization in this range is easily synthesized industrially, and thus is easily available. From the viewpoint of making it possible to not only achieve such characteristics but also further suppress cure shrinkage, the degree of polymerization is more preferably 3 to 50, further preferably 3 to 10.

The silicone compound having the repeating unit represented by the formula (1) preferably contains no alkoxy group. Thus, cure shrinkage due to dealcoholization reaction is not caused, and when the silicone compound is used in combination with the branched imide resin (B), the resin sheet can have excellent insulation breakdown resistance.

The silicone compound having the repeating unit represented by the formula (1) may have, for example, a linear structure or a ring structure.

Examples of the silicone compound having a ring structure include a cyclic silicone compound represented by the following formula (2). The cyclic silicone compound represented by the formula (2) is suitable because of being small in cure shrinkage. 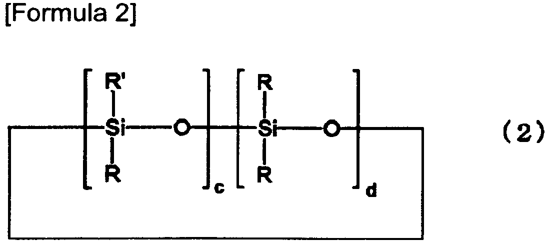 wherein R and R' are as defined in the formula (1), c denotes an integer of 3 to 5, d denotes an integer of 0 to 2, the sum of c and d is equal to an integer of 3 to 5, and the respective repeating units can be randomly polymerized.

In the formula (2), preferably, c denotes an integer of 3 to 4, d denotes an integer of 0 to 1, and the sum of c and d is equal to 4.

With respect to the cyclic silicone compound represented by the formula (2), a cyclic silicone compound represented by the following formula (2') is more preferable from the viewpoint that the effect of the present invention is more effectively and certainly exerted. 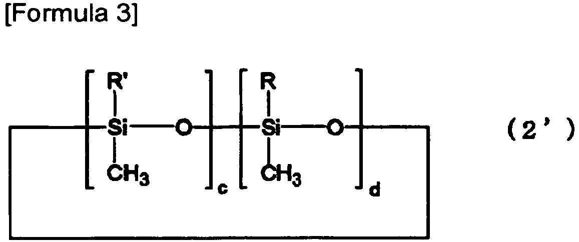 wherein R, R', c and d are as defined in the formula (2).

Examples of the silicone compound having a linear structure include a linear silicone compound represented by the following formula (3). 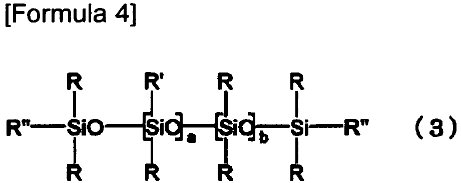 wherein R and R' are as defined in the formula (1), R" represents R or R', R, R' (when a denotes 2 or more) and R" may be the same or different from one another, a denotes an integer of 1 to 10, b denotes an integer of 0 to 8, the sum of a and b is equal to an integer of 2 to 10, provided that when a denotes 1, R"(s) at both ends represent R', and when a denotes 2, at least one of R"(s) represents R', and the respective repeating units can be randomly polymerized.

In the formula (3), preferably, a denotes an integer of 4 to 8, b denotes an integer of 0 to 4, and the sum of a and b is equal to an integer of 4 to 8.

With respect to the linear silicone compound represented by the formula (3), a linear silicone compound represented by the following formula (3') is more preferable from the viewpoint that the effect of the present invention is more effectively and certainly exerted. 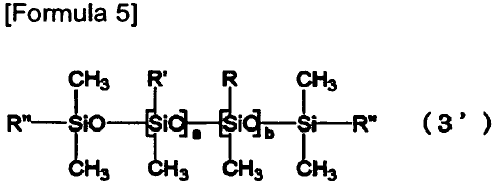 wherein R, R', R", a and b are as defined in the formula (3).

With respect to the linear silicone compound represented by the formula (3), a linear silicone compound represented by the following formula (4) is further preferable from the viewpoint that the effect of the present invention is more effectively and certainly exerted. 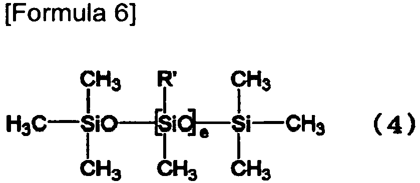 wherein R' is as defined in above, and e denotes an integer of 3 to 10.

In the formula (4), e preferably denotes an integer of 3 to 8.

The silicone compound having the repeating unit represented by the formula (1) is further preferably a cyclic silicone compound represented by the following formula (5) from the viewpoint that the effect of the present invention is more effectively and certainly exerted. 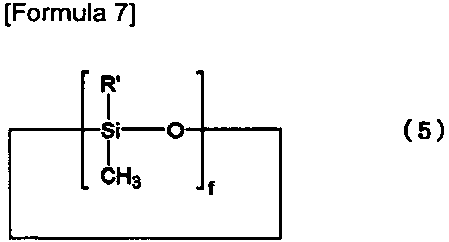 wherein R' is as defined in the formula (1), and f denotes an integer of 3 to 5.

In the formula (5), f preferably denotes 4.

The aliphatic epoxy-modified silicone compound (A) preferably includes 50% by mass or more of a compound in which f denotes 4 in the formula (5), from the viewpoint that the effect of the present invention is more effectively and certainly exerted.

Specific examples of the aliphatic epoxy-modified silicone compound (A) include (CH₃)₃SiO(R'CH₃SiO)₅Si(CH₃)₃, (CH₃)₃SiO(R'CH₃SiO)₆Si(CH₃)₃, (CH₃)₃SiO(R'CH₃SiO)₇Si(CH₃)₃, (CH₃)₃SiO(R'CH₃SiO)₈Si(CH₃)₃, (CH₃)₃SiO(R'CH₃SiO)₉Si(CH₃)₃, (CH₃)₃SiO(R'CH₃SiO)₁₀Si(CH₃)₃, R'(CH₃)₂SiO(R'CH₃SiO)Si(CH₃)₂R', R'(CH₃)₂SiO(R'CH₃SiO)₂Si(CH₃)₂R', R'(CH₃)₂SiO(R'CH₃SiO)₃Si(CH₃)₂R', R'(CH₃)₂SiO(R'CH₃SiO)₄Si(CH₃)₂R', R'(CH₃)₂SiO(R'CH₃SiO)₅Si(CH₃)₂R', R'(CH₃)₂SiO(R'CH₃SiO)₆Si(CH₃)₂R', R'(CH₃)₂SiO(R'CH₃SiO)₇Si(CH₃)₂R', R'(CH₃)₂SiO(R'CH₃SiO)₈Si(CH₃)₂R', R'(CH₃)₂SiO(R'CH₃SiO)₉Si(CH₃)₂R', R'(CH₃)₂SiO(R'CH₃SiO)₂((CH₃)₂SiO)₂Si(CH₃)₂R'.

Other specific examples of the aliphatic epoxy-modified silicone compound (A) include R'(CH₃)₂SiO(R'CH₃SiO)₃((CH₃)₂SiO)Si(CH₃)₂R', R'(CH₃)₂SiO(R'CH₃SiO)₃((CH₃)₂SiO)₂Si(CH₃)₂R'. R'(CH₃)₂SiO(R'CH₃SiO)₄((CH₃)₂SiO)Si(CH₃)₂R', R'(CH₃)₂SiO(R'CH₃SiO)₄((CH₃)₂SiO)₂Si(CH₃)₂R', R'(CH₃)₂SiO(R'CH₃SiO)₅((CH₃)₂SiO)Si(CH₃)₂R'. R'(CH₃)₂SiO(R'CH₃SiO)₅((CH₃)₂SiO)₂Si(CH₃)₂R', R'(CH₃)₂SiO(R'CH₃SiO)₅((CH₃)₂SiO)₃Si(CH₃)₂R', R'(CH₃)₂SiO(R'CH₃SiO)₆((CH₃)₂SiO)Si(CH₃)₂R'.

Furthermore, still other specific examples of the aliphatic epoxy-modified silicone compound (A) include R'(CH₃)₂SiO(R'CH₃SiO)₆((CH₃)₂SiO)₂Si(CH₃)₂R'. R'(CH₃)₂SiO(R'CH₃SiO)₆((CH₃)₂SiO)₃Si(CH₃)₂R', R'(CH₃)₂SiO(R'CH₃SiO)₇((CH₃)₂SiO)Si(CH₃)₂R', R'(CH₃)₂SiO(R'CH₃SiO)₇((CH₃)₂SiO)₂Si(CH₃)₂R', R'(CH₃)₂SiO(R'CH₃SiO)₇((CH₃)₂SiO)₃Si(CH₃)₂R', R'(CH₃)₂SiO(R'CH₃SiO)₇((CH₃)₂SiO)₄Si(CH₃)₂R', R'(CH₃)₂SiO(R'CH₃SiO)₈((CH₃)₂SiO)Si(CH₃)₂R', R'(CH₃)₂SiO(R'CH₃SiO)₈((CH₃)₂SiO)₂Si(CH₃)₂R', R'(CH₃)₂SiO(R'CH₃SiO)₈((CH₃)₂SiO)₃Si(CH₃)₂R'.

In addition, still other specific examples of the aliphatic epoxy-modified silicone compound (A) include R'(CH₃)₂SiO(R'CH₃SiO)₄(R⁰CH₃SiO)Si(CH₃)₂R', R'(CH₃)₂SiO(R'CH₃SiO)₅(R⁰CH₃SiO)Si(CH₃)₂R', R'(CH₃)₂SiO(R'CH₃SiO)₆(R°CH₃SiO)Si(CH₃)₂R', R'(CH₃)₂SiO(R'CH₃SiO)₇(R⁰CH₃SiO)Si(CH₃)₂R', R'(CH₃)₂SiO(R'CH₃SiO)₈(R⁰CH₃SiO)Si(CH₃)₂R', R'(CH₃)₂SiO(R'CH₃SiO)₉(R⁰CH₃SiO)Si(CH₃)₂R', (R'CH₃SiO)₃, (R'CH₃SiO)₄, (R'CH₃SiO)₅, (R'CH₃SiO)₃((CH₃)₂SiO), (R'CH₃SiO)₃(C₃H₇(CH₃)SiO). The aliphatic epoxy-modified silicone compound (A), however, is not limited thereto. In the above specific examples, R' is as defined in the formula (1), and R⁰ represents a methacryloxypropyl group. The aliphatic epoxy-modified silicone compound (A) can be used singly or in combinations of two or more.

The above aliphatic epoxy-modified silicone compound (A) can be produced by a known method. Specifically, for example, the aliphatic epoxy-modified silicone compound (A) can be obtained by addition-reacting (hydrosilylation of) an allyl epoxy compound (for example, 4-vinylcyclohexene oxide) with an organohydrogenpolysiloxane using a catalyst such as a platinum compound. As the above aliphatic epoxy-modified silicone compound (A), a commercial product can also be used. As such a commercial product, for example, X-40-2670, X-22-163A, X-22-163B, X-22-169AS, X-22-169B, X-41-1053 or KF-105 (produced by Shin-Etsu Chemical Co., Ltd.) is suitably used.

The content of the aliphatic epoxy-modified silicone compound (A) contained in the resin composition for use in the present embodiment is not particularly limited, but is preferably 20 to 80 parts by mass, more preferably 25 to 75 parts by mass, based on 100 parts by mass of the total of the aliphatic epoxy-modified silicone compound (A) and the branched imide resin (B) in the resin composition. When the content of the aliphatic epoxy-modified silicone compound (A) is within such a preferable range, the resulting resin sheet and metal foil-clad laminate tend to have a more suppressed discoloration due to a heating treatment or a light irradiation treatment to exhibit a more efficiently suppressed reduction in reflectance.

The branched imide resin (B) contained in the resin composition for use in the present embodiment is not particularly limited as long as it has an isocyanurate group (isocyanurate ring) and a carboxyl group together with an imide group. The branched imide resin (B) is preferably a multi-branched imide resin that has an isocyanurate ring and a plurality of cyclic imide moieties having a carboxyl group, in which a large number of such cyclic imide moieties are bonded to the isocyanurate ring, from the viewpoint that the effect of the present invention is more effectively and certainly exerted. The branched imide resin (B) is more preferably an imide resin having an alicyclic structure, namely, an alicyclic imide resin (having no aromatic ring). Examples of such an alicyclic imide resin include a multi-branched alicyclic imide resin that has an isocyanurate ring and a plurality of aliphatic cyclic imide moieties having a carboxyl group each bonded to each nitrogen atom in the isocyanurate ring via an aliphatic ring.

Such a branched imide resin (B) having an isocyanurate ring and a carboxyl group is contained in the resin composition together with the aliphatic epoxy-modified silicone compound (A), the titanium dioxide (C) and the wetting and dispersing agent (D) to thereby significantly increase peel strength of the resin sheet from the metal foil and heat resistance. Additionally, the light reflectance of the resin sheet in an ultraviolet region and in a visible light region tends to be significantly increased to remarkably suppress the reduction in light reflectance due to a heating treatment and a light irradiation treatment.

As the above branched imide resin (B), for example, one represented by the following formula (6) is preferable. 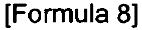 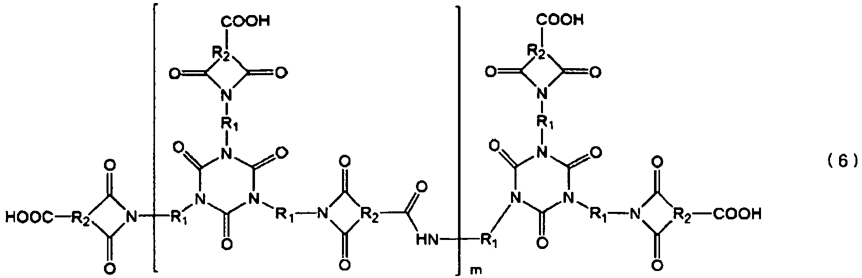 wherein a plurality of R₁(s) each independently represent a divalent alicyclic group, a plurality of R₂(s) each independently represent a trivalent alicyclic group, and m denotes an integer of 1 to 10.

When the branched imide resin (B) is one represented by the formula (6), the weight average molecular weight (Mw) thereof is preferably 2000 to 35000, more preferably 2000 to 10000.

In the formula (6), the alicyclic group represent by R₁ preferably has a saturated aliphatic ring, and is preferably a divalent group having 6 to 20 carbon atoms. The alicyclic group is a residue of an alicyclic diamine or an alicyclic diisocyanate as a raw material. Examples of the alicyclic diamine include 4,4'-diamino-dicyclohexylmethane, 3,3'-dimethyl-4,4'-diamino-dicyclohexylmethane, 3,3'-diethyl-4,4'-diamino-dicyclohexylmethane, 3,3',5,5'-tetramethyl-4,4'-diaminodicyclohexylmethane, 3,3',5,5'-tetraethyl-4,4'-diamino-dicyclohexylmethane, 3,5-diethyl-3',5'-dimethyl-4,4'-diaminodicyclohexylmethane, 1,4-cyclohexanediamine, 1,3-cyclohexanediamine, isophoronediamine, 2,2-bis[4-(4-aminocyclohexyloxy)cyclohexyl]propane, bis[4-(3-aminocyclohexyloxy)cyclohexyl]sulfone, bis[4-(4-aminocyclohexyloxy)cyclohexyl]sulfone, 2,2-bis[4-(4-aminocyclohexyloxy)cyclohexyl]hexafluoropropane, bis[4-(4-aminocyclohexyloxy)cyclohexyl]methane, 4,4'-bis(4-aminocyclohexyloxy)dicyclohexyl, bis[4-(4-aminocyclohexyloxy)cyclohexyl]ether, bis[4-(4-aminocyclohexyloxy)cyclohexyl]ketone, 1,3-bis(4-aminocyclohexyloxy)benzene, 1,4-bis(4-aminocyclohexyloxy)benzene, (4,4'-diamino)dicyclohexylether, (4,4'-diamino)dicyclohexylsulfone, (4,4'-diaminocyclohexyl)ketone, (3,3'-diamino)benzophenone, 2,2'-dimethylbicyclohexyl-4,4'-diamine, 2,2'-bis(trifluoromethyl)dicyclohexyl-4,4'-diamine, 5,5'-dimethyl-2,2'-sulfonyldicyclohexyl-4,4'-diamine, 3,3'-dihydroxydicyclohexyl-4,4'-diamine, (4,4'-diamino)dicyclohexylmethane, (4,4'-diamino)dicyclohexylether, (3,3'-diamino)dicyclohexylether and 2,2-bis(4-aminocyclohexyl)propane. The alicyclic diamine, however, is not limited thereto. Examples of the alicyclic diisocyanate include one in which an amino group of the alicyclic diamine is substituted with an isocyanate group, but not limited thereto.

In the formula (6), the alicyclic group represented by R₂ preferably has a saturated aliphatic ring, and is preferably a trivalent aliphatic group having 6 to 20 carbon atoms. The alicyclic group is a residue of an alicyclic tricarboxylic acid or an anhydride as a raw material. Examples of the alicyclic tricarboxylic acid include cyclohexane-1,2,3-tricarboxylic acid, cyclohexane-1,2,4-tricarboxylic acid, cyclohexane-1,3,5-tricarboxylic acid, 5-methylcyclohexane-1,2,4-tricarboxylic acid, 6-methylcyclohexane-1,2,4-tricarboxylic acid and 3-methylcyclohexane-1,2,4-tricarboxylic acid. The alicyclic tricarboxylic acid is not limited thereto.

The acid value of the above branched imide resin (B) is preferably 10 to 200 mgKOH/g, more preferably 10 to 100 mgKOH/g on the solid content basis, from the viewpoints of the solubility in an organic solvent, curing characteristics, and the like. In the present specification, the acid value is measured by titration of an aqueous 0.1 mol/L potassium hydroxide solution according to JIS K 0070.

The branched imide resin (B) preferably includes a modified branched imide resin obtained by reacting the branched imide resin having an isocyanurate group and a carboxyl group with one or more compounds selected from the group consisting of an epoxy compound, an alcohol compound and an amine compound. While the carboxyl group in the molecular structure of the branched imide resin (B) has curing-accelerating ability in a curing reaction, the above modified branched imide resin can properly control curing-accelerating ability of the carboxyl group.

The degree of modification of the carboxyl group in the modified branched imide resin can be measured by an acid value. The acid value is preferably 10 to 200 mgKOH/g in order to adjust curing-accelerating ability by the phosphorus curing accelerator (E) described later.

As the branched imide resin (B), those synthesized by an ordinary method or those commercially marketed may be used. Specific commercial products include the branched imide resin represented by the formula (6) (trade name: V-8002 (produced by Dic Corporation)), the branched imide resin that is epoxy-modified (trade name: ELG-941 (produced by Dic Corporation)), the branched imide resin that is amine-modified (trade name: ELG-1301 (produced by Dic Corporation)) and the branched imide resin that is alcohol-modified (trade name: ELG-1302 (produced by Dic Corporation)).

The branched imide resin (B) is used singly or in combinations of two or more.

The resin sheet of the present embodiment is preferably white from the viewpoint of being useful for use in an LED-mounting printed-wiring board. The resin composition for use in the present embodiment contains the titanium dioxide (C) as an inorganic filling material for allowing the resin sheet of the present embodiment to be white or closer to white. From the viewpoint of more increasing the light reflectance in an ultraviolet region and in a visible light region, titanium dioxide having a rutile type or an anatase type crystal structure is preferable.

The average particle size (D50) of the titanium dioxide (C) is not particularly limited, but is preferably 5 µm or less, more preferably 0.5 µm or less. The titanium dioxide (C) can be used singly or in combinations of two or more. For example, a plurality of kinds of titanium dioxide, having a different particle size distribution and a different average particle size, can also be used in appropriate combination. In the present specification, the average particle size (D50) means the median diameter, which is the value at which, when the particle size distribution of a powder measured is divided to two areas, the area having larger particle sizes and the area having smaller particle sizes are the same in terms of the number of particles. More specifically, the average particle size (D50) herein means the value at which, when the particle size distribution of a powder dispersed in methyl ethyl ketone is measured by a laser diffraction scattering particle size distribution measuring apparatus, the cumulative volume from smaller particles reaches 50% of the entire volume.

From the viewpoint of more increasing the light reflectance in an ultraviolet region and in a visible light region, the titanium dioxide (C) is preferably subjected to a surface treatment with one or more oxides selected from the group consisting of SiO₂ (silica), Al₂O₃ (alumina), ZrO₂ (zirconia) and ZnO (zinc oxide). In other words, the particle of the titanium dioxide (C) is preferably covered with a covering layer containing one or more oxides selected from the group consisting of SiO₂, Al₂O₃, ZrO₂ and ZnO. From the same viewpoint, the titanium dioxide (C) is further preferably subjected to a surface treatment with one or more oxides selected from the group consisting of SiO₂, Al₂O₃, ZrO₂ and ZnO and then subjected to one or more treatments selected from the group consisting of a polyol treatment, a silane coupling agent treatment and an amine treatment. In other words, the particle of the titanium dioxide (C) more preferably contains one or more oxides selected from the group consisting of SiO₂, Al₂O₃, ZrO₂ and ZnO, and is preferably covered with a covering layer subjected to one or more treatments selected from the group consisting of a polyol treatment, a silane coupling agent treatment and an amine treatment.

When the titanium dioxide (C) subjected to a surface treatment is used, the titanium dioxide (C) is preferably subjected to a surface treatment with one or more oxides selected from the group consisting of SiO₂, Al₂O₃, ZrO₂ and ZnO, and preferably contains 0.5 to 15 parts by mass of the oxides based on 100 parts by mass of the total amount of the titanium dioxide subjected to a surface treatment. More preferably, the titanium dioxide (C) contains 1 to 11 parts by mass of the oxides based on 100 parts by mass of the total amount of the titanium dioxide subjected to a surface treatment. When the amount of the surface treatment is within such a preferable range, discoloration due to a heating treatment or a light irradiation treatment tends to be more suppressed to further suppress the reduction in light reflectance, without causing an excessive reduction in light reflectance of the resin sheet in an ultraviolet region and in a visible light region. The titanium dioxide (C) is more preferably subjected to a surface treatment with 3 to 11 parts by mass of SiO₂ and 1 to 3 parts by mass of Al₂O₃ based on 100 parts by mass of the total amount of the titanium dioxide (C) subjected to a surface treatment.

The content of the titanium dioxide (C) contained in the resin composition for use in the present embodiment is not particularly limited, but is preferably 10 to 300 parts by mass, more preferably 50 to 250 parts by mass, based on 100 parts by mass of the total of the aliphatic epoxy-modified silicone compound (A) and the branched imide resin (B). When the content of the titanium dioxide (C) is within such a preferable range, characteristics and processability of the resulting metal foil-clad laminate tend to be more easily enhanced without causing an excessive reduction in light reflectance of the resin sheet in an ultraviolet region and in a visible light region. Specifically, the occurrence of breaking, cracking and the like due to conveyance and the like in production of a printed-wiring board and a chip LED is suppressed. Furthermore, the occurrence of the following failure tends to be suppressed: a drill bit and a dicing blade are broken and damaged and processing itself cannot be performed in mechanical drill processing on a printed-wiring board and in dicing processing on a chip LED.

The wetting and dispersing agent (D) contained in the resin composition for use in the present embodiment particularly makes the dispersibility between the resin in the resin composition and the titanium dioxide (C) good to thereby result in the increase in light reflectance of the resin sheet in an ultraviolet region and in a visible light region, suppressing the reduction in light reflectance due to a heating treatment and a light irradiation treatment. The wetting and dispersing agent (D) is not particularly limited, but a dispersion stabilizer generally used for paints can be suitably used. The wetting and dispersing agent (D) is, in particular, preferably a polymer wetting and dispersing agent having an acidic group from the viewpoint that the effect of the present invention is more effectively and certainly exerted. From the same viewpoint, the acid value of the wetting and dispersing agent (D) is preferably 20 to 200 mgKOH/g. Furthermore, the wetting and dispersing agent (D) is more preferably a polymer wetting and dispersing agent having an acid value of 20 to 200 mgKOH/g. Specific examples thereof include polymer wetting and dispersing agents produced by BYK Japan, such as BYK-W161, BYK-W903, BYK-W940, BYK-W996, BYK-W9010, Disper-BYK110, Disper-BYK111 and Disper-BYK180 (all are trade names). The wetting and dispersing agent (D), however, is not limited thereto. The wetting and dispersing agent (D) can be used singly or in combinations of two or more.

The content of the wetting and dispersing agent (D) contained in the resin composition for use in the present embodiment is not particularly limited, but is preferably 0.05 to 10 parts by mass, more preferably 0.1 to 4.0 parts by mass, further preferably 0.5 to 3.0 parts by mass, based on 100 parts by mass of the total of the aliphatic epoxy-modified silicone compound (A) and the branched imide resin (B). When the content of the wetting and dispersing agent (D) is within such a preferable range, the heat resistance of the resin sheet tends to be more increased and the dispersibility between the resin in the resin composition and the titanium dioxide (C) tends to be more increased to suppress the variation in forming.

The phosphorus curing accelerator (E) that can be contained in the resin composition for use in the present embodiment particularly promotes curing of the resin composition for use in the present embodiment to thereby result in the increase in light reflectance of the resin sheet in an ultraviolet region and in a visible light region, suppressing the reduction in light reflectance due to a heating treatment and a light irradiation treatment. The phosphorus curing accelerator (E) is not particularly limited as long as it has curing-accelerating ability. Examples of the phosphorus curing accelerator (E) include methyltributylphosphonium dimethyl phosphate (trade name: PX-4MP (produced by Nippon Chemical Industrial Co., Ltd.)), butylphosphonium diethyl phosphodithionate (trade name: PX-4ET (produced by Nippon Chemical Industrial Co., Ltd.)), tetrabutylphosphonium tetrafluoroborate (trade name: PX-4FB (produced by Nippon Chemical Industrial Co., Ltd.)), triphenylphosphine (produced by Tokyo Chemical Industry Co., Ltd.) and phosphorus-containing cyanic acid ester (trade name: FR-300 (produced by Lonza Japan)). The phosphorus curing accelerator (E) can be used singly or in combinations of two or more.

Among them, methyltributylphosphonium dimethyl phosphate is preferable from the viewpoint of being capable of suppressing the reduction in discoloration resistance of the resin sheet due to heating treatment and light irradiation treatment and resulting in the enhancement in glass transition temperature.

The content of the phosphorus curing accelerator (E) that can be contained in the resin composition for use in the present embodiment is preferably 0.1 to 10 parts by mass, more preferably 0.5 to 8 parts by mass, based on 100 parts by mass of the total of the aliphatic epoxy-modified silicone compound (A) and the branched imide resin (B). When the content of the phosphorus curing accelerator (E) is within this range, the reduction in discoloration resistance of the resulting copper-clad laminate due to heating treatment and light irradiation treatment can be suppressed and the glass transition temperature of the resin sheet can be enhanced.

The epoxy monomer (F) having one or more epoxy rings (except for the component (A)), which can be contained in the resin composition for use in the present embodiment, is not particularly limited as long as it is a monomer having one or more epoxy structures. As such a component (F), an epoxy monomer having one or two epoxy rings in one molecule is preferable from the viewpoint of being more excellent in heat resistance and light discoloration resistance.

When such an epoxy monomer (F) is used together with the aliphatic epoxy-modified silicone compound (A), the branched imide resin (B), the titanium dioxide (C) and the wetting and dispersing agent (D), not only the reduction in melt viscosity of the resin composition tends to enhance the formability of the metal foil-clad laminate, but also the peel strength of the resin sheet from the metal foil tends to be more increased.

The epoxy monomer (F) having one or more epoxy rings specifically includes monomers represented by the following formula (7) and the following formula (8). The component (F) can be used singly or in combinations of two or more.

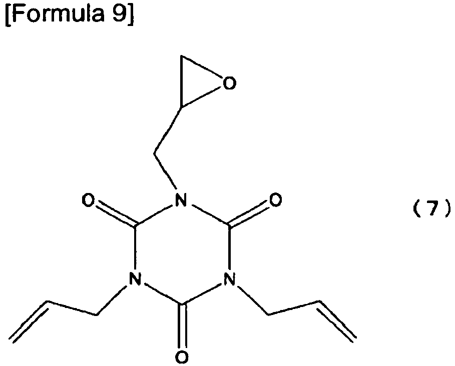

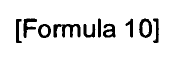

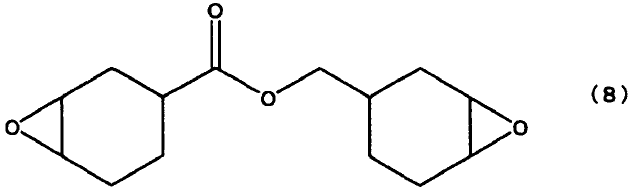

As the epoxy monomer (F) having one or more epoxy rings, a commercial product can also be used. Examples of the monomer represented by the formula (7) include DA-MGIC (trade name, produced by Shikoku Chemicals Corporation), and examples of the monomer represented by the formula (8) include Celloxide 2021 P (trade name, produced by Daicel Corporation).

The content of the epoxy monomer (F) having one or more epoxy rings contained in the resin composition for use in the present embodiment is not particularly limited, but is preferably 0.5 to 10 parts by mass, more preferably 1 to 10 parts by mass, based on 100 parts by mass of the total of the aliphatic epoxy-modified silicone compound (A) and the branched imide resin (B). When the content of the epoxy monomer (F) having one or more epoxy rings is within such a preferable range, the reduction in reflectance of the resulting metal foil-clad laminate based on discoloration due to a heating treatment or a light irradiation treatment can be suppressed. In addition, not only the reduction in melt viscosity of the resin composition can enhance the formability of the metal foil-clad laminate, but also the peel strength of the resin sheet from the metal foil tends to be more increased.

The resin composition for use in the present embodiment can also contain an epoxy resin other than the above. Examples of such an epoxy resin include a bisphenol E-based epoxy resin, a bisphenol F-based epoxy resin, a bisphenol S-based epoxy resin, a phenol novolac-based epoxy resin, a cresol novolac-based epoxy resin, a biphenyl-based epoxy resin, a naphthalene-based epoxy resin, a trifunctional phenol-based epoxy resin, a tetrafunctional phenol-based epoxy resin, a glycidyl ester-based epoxy resin, a phenolaralkyl-based epoxy resin, a biphenyl aralkyl-based epoxy resin, a naphthol aralkyl-based epoxy resin, a dicyclopentadiene-based epoxy resin, an alicyclic epoxy resin, an isocyanurate ring-containing epoxy, and halides thereof. Such an epoxy resin can be used singly or as an appropriate mixture of two or more.

Furthermore, the resin composition for use in the present embodiment may also contain other inorganic filling material than the above titanium dioxide (C). Examples of other inorganic filling material include silicas such as natural silica, synthetic silica, fused silica, amorphous silica and hollow silica, boehmite, molybdenum compounds such as molybdenum oxide and zinc molybdate, zinc borate, zinc stannate, alumina, zinc oxide, magnesium oxide, zirconium oxide, aluminum hydroxide, boron nitride, clay, kaolin, talc, fired clay, fired kaolin, fired talc, mica, short glass fibers (including fine powders of glasses such as E glass, T glass, D glass, S glass and Q glass), hollow glass and spherical glass. Other inorganic filling material, however, is not limited thereto. Among them, silicas are preferably used as other inorganic filling material from the viewpoints of resulting in no excessive reduction in light reflectance of the resin sheet and improving laminate characteristics such as rate of thermal expansion. Other inorganic filling material listed here can be used singly or in combinations of two or more.

The average particle size (D50) of other inorganic filling material is not particularly limited, but the average particle size (D50) is 0.2 to 5 µm in terms of dispersibility. The content of other inorganic filling material in the resin composition is preferably 300 parts by mass or less, more preferably 250 parts by mass or less, based on 100 parts by mass of the total of the aliphatic epoxy-modified silicone compound (A) and the branched imide resin (B). Herein, the lower limit of the content is not particularly limited, and may be more than 0 parts by mass based on 100 parts by mass of the total of the aliphatic epoxy-modified silicone compound (A) and the branched imide resin (B).

The resin composition for use in the present embodiment can further contain other curing accelerator than the phosphorus curing accelerator (E), if necessary. Such other curing accelerator may be one known or one generally used, and is not particularly limited. Examples of other curing accelerator include organic salts of metal such as copper, zinc, cobalt, and nickel, imidazoles and derivatives thereof, and tertiary amines. Other curing accelerator is used singly or in combinations of two or more.

The resin composition for use in the present embodiment may also contain other component than the above as long as the desired characteristics are not impaired. Examples of such an optional blending material include a thermosetting resin and a thermoplastic resin other than the above, and various polymer compounds such as oligomers and elastomers thereof, as well as a flame retardant compound and various additives. These are not particularly limited and may be those generally used in the art. Specific examples of the flame retardant compound include nitrogen-containing compounds such as melamine and benzoguanamine, and an oxazine ring-containing compound. Specific examples of the additives include an ultraviolet absorber, an antioxidant, a photopolymerization initiator, a fluorescent whitener, a photosensitizer, a dye, a pigment, a thickener, a lubricant, an antifoamer, a dispersant, a leveling agent, a gloss agent, a polymerization inhibitor and a silane coupling agent. Such an optional blending material can be used singly or in combinations of two or more.

Furthermore, the resin composition for use in the present embodiment may also further contain a solvent, if necessary. For example, when an organic solvent is used, the viscosity of the resin composition in preparation can be lowered, resulting in the enhancement in handleability. The type of the solvent is not particularly limited as long as the mixture of the component (A) and the component (B) can be dissolved in or be compatible with the solvent. Specific examples thereof include ketones such as acetone, methyl ethyl ketone, methyl isobutyl ketone and cyclohexanone, aromatic hydrocarbons such as benzene, toluene and xylene, amides such as dimethylformamide and dimethylacetamide, and propylene glycol methyl ether and acetate thereof. The solvent, however, is not particularly limited. The solvent can be used singly or in combinations of two or more.

The resin composition for use in the present embodiment can be prepared by an ordinary method. The preparation method thereof is not particularly limited as long as it is a method that can provide a resin composition containing the aliphatic epoxy-modified silicone compound (A), the branched imide resin (B), the titanium dioxide (C) and the wetting and dispersing agent (D), and other optional components described above. For example, the epoxy resin, the branched imide resin, the titanium dioxide and the wetting and dispersing agent can be sequentially blended with the solvent and the resultant can be sufficiently stirred to thereby prepare the resin composition of the present embodiment with the respective components being uniformly mixed.

When the resin composition is prepared, an organic solvent can be used, if necessary. The type of the organic solvent is not particularly limited as long as the mixture of the epoxy-modified silicone resin (A) and the branched imide resin (B) can be dissolved in or be compatible with the organic solvent. Specific examples thereof include the same as recited above.

Herein, when the resin composition is prepared, a known treatment for uniformly dissolving or dispersing the respective components (stirring, mixing, and kneading treatments, and the like) can be performed. For example, in a method for stirring/dispersing the titanium dioxide (C) in the resin composition, a stirring tank provided with a stirring machine having proper stirring ability is used to perform a stirring/dispersing treatment, thereby resulting in the improvement in dispersibility in the resin composition. The stirring, mixing, and kneading treatments can be appropriately performed by using, for example, an apparatus for mixing, such as a ball mill and a bead mill, or a known apparatus such as a planetary centrifugal mixing apparatus.

A resin sheet with a support in the present embodiment is obtained by, for example, impregnating a support with the resin composition for drying. The resin sheet of the present embodiment is formed on the support as described above. The resin sheet thus obtained includes the layer including the resin composition. Herein, the support may be if necessary peeled from the resin sheet or etched after the drying.

The support is not particularly limited, and examples thereof include a film containing one or more resins selected from the group consisting of polyvinyl chloride, polyvinylidene chloride, polybutene, polybutadiene, polyurethane, an ethylene-vinyl acetate copolymer, polyethylene terephthalate, polyethylene, polypropylene, an ethylene-propylene copolymer, polymethylpentene and polybutylene terephthalate, as well as a release film in which the surface of such a film is coated with a release agent, an organic film such as a polyimide film, and conductor foil such as aluminum foil and copper foil. Among them, particularly, a polyethylene terephthalate film and copper foil are preferable. In addition, the thickness of the support is not particularly limited, and may be, for example, 0.002 to 0.1 mm.

The method for impregnating the support with the resin composition is not particularly limited, and examples include a coating method. More specifically, the method includes a method for coating the support with the resin composition using a bar coater, a die coater, a doctor blade, a baker applicator or the like.

The drying conditions are not particularly limited, but the drying is preferably performed at a temperature of 20 to 200°C for 1 to 90 minutes. When the drying is performed at a temperature of 20°C or higher, the light volatile fraction can be more inhibited from remaining in the resin composition, and when the drying is performed at a temperature of 200°C or lower, the curing of the resin composition can be prevented from rapidly progressing.

The thickness of a layer including the resin composition (hereinafter, simply also referred to as "resin layer") can be controlled by the concentration of the resin composition and the thickness of impregnating (coating). From the viewpoints that the light volatile fraction is more favorably removed in the drying of the resin composition impregnated and that the function as the resin sheet is more effectively and certainly exerted, the thickness of the resin layer is preferably 0.1 to 500 µm.

The laminate of the present embodiment can be obtained by peeling the resin layer of the resin sheet with a support from the support, and, if desired, stacking at least one sheet of the resin layer on other resin layer or metal layer for lamination forming.

Furthermore, the metal foil-clad laminate of the present embodiment can be obtained by disposing metal foil on one surface or both surfaces of the resin sheet for lamination forming.

The metal foil used here is not particularly limited as long as it can be used for a printed-wiring board material. For example, known copper foil such as rolled copper foil or electrolytic copper foil can be used. The thickness of the metal foil is not particularly limited, but is preferably 2 to 70 µm, more preferably 2 to 35 µm. The method for forming the metal foil-clad laminate and the forming conditions are not also particularly limited, and a general procedure and general conditions for laminates and multi-layer plates for printed-wiring boards can be applied. For example, when the metal foil-clad laminate is formed, a multistage pressing machine, a multistage vacuum pressing machine, a continuous forming machine, an autoclave forming machine or the like can be used. In the formation, the temperature is generally in the range from 100 to 300°C, the pressure is in the range from 2 to 100 kgf/cm² as surface pressure, and the heating time is generally in the range from 0.05 to 5 hours. Furthermore, post-curing of the resin sheet can also be performed at a temperature of 150 to 300°C, if necessary.

In addition, the laminate and the metal foil-clad laminate including the resin sheet of the present embodiment can be combined with a wiring board separately produced for an inner layer for lamination forming, providing a multi-layer plate.

The metal foil-clad laminate of the present embodiment, on which a predetermined wiring pattern is formed, can be thus suitably used as a printed-wiring board. Then, the metal foil-clad laminate of the present embodiment not only is excellent in heat resistance, but also is high in light reflectance in an ultraviolet region and in a visible light region and exhibits a small reduction in light reflectance due to a heating treatment and a light irradiation treatment. Therefore, the metal foil-clad laminate of the present embodiment can be significantly effectively used as a printed-wiring board that is required to have such performances, in particular, as an LED-mounting printed-wiring board.

### Examples

Hereinafter, the present invention is described in more detail with reference to Preparation Examples, Examples and Comparative Examples, but the present invention is not limited to these Examples at all.

### (Example 1)

Fifty-five parts by mass of an aliphatic epoxy-modified silicone compound represented by the following formula (10) (trade name: X-40-2670 (produced by Shin-Etsu Chemical Co., Ltd.)), 45 parts by mass of a branched imide resin (trade name: V-8002 (acid value: 127 mgKOH/g), produced by Dic Corporation), 200 parts by mass of titanium dioxide subjected to a surface treatment (trade name: CR90 (subjected to a surface treatment with 1 to 5 parts by mass of SiO₂ and 1 to 3 parts by mass of Al₂O₃ based on 100 parts by mass of the total of the titanium dioxide subjected to a surface treatment), produced by Ishihara Sangyo Kaisha Ltd.), 1.75 parts by mass of a wetting and dispersing agent (trade name: BYK-W903, produced by BYK Japan) and 3 parts by mass of a silane coupling agent (trade name: Z6040, produced by Dow Corning Toray Co., Ltd.)) were stirred and mixed in a homomixer to provide a varnish. This varnish was diluted with methyl ethyl ketone, a polyethylene terephthalate film having a thickness of 0.05 mm was coated with the varnish diluted, and heated at 150°C for 2 minutes to provide a support with a resin layer in which the thickness of the resin layer was 50 µm. Then, in this support with a resin layer, the resin layer was peeled from the polyethylene terephthalate film. One sheet of the resin layer was stacked on the upper surface of one (thickness: 0.8 mm) in which copper foil on each of both surfaces of a double-sided copper-clad laminate (trade name: HL832NS, produced by Mitsubishi Gas Chemical Company, Inc.) was etched and removed, and electrolytic copper foil of 12 µm (trade name: JTC-LPZ foil, manufactured by JX Nippon Mining & Metals Corporation) was disposed thereon to provide a laminate. The laminate was subjected to pressure-forming in the lamination direction using a vacuum pressing machine under a vacuum of 30 mmHg or less at a surface pressure of 30 kgf/cm² and a temperature of 220°C for 150 minutes, thereby providing a copper-clad laminate having a thickness of 0.85 mm.

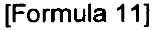

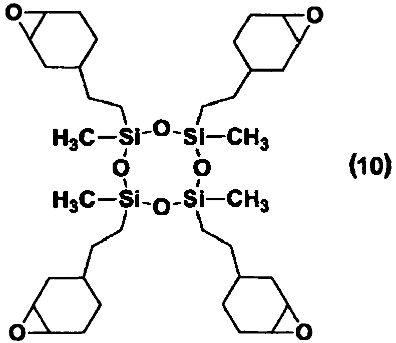

### (Example 2)

The same manner as in Example 1 was performed to provide a copper-clad laminate having a thickness of 0.85 mm, except that 45 parts by mass of an epoxy-modified branched imide resin (trade name: ELG-941 (acid value: 32 mgKOH/g)) was used instead of 45 parts by mass of the branched imide resin and 5 parts by mass of methyltributylphosphonium dimethyl phosphate (trade name: PX-4MP (produced by Nippon Chemical Industrial Co., Ltd.)) was further used as a phosphorus curing accelerator.

### (Example 3)

The same manner as in Example 1 was performed to provide a copper-clad laminate having a thickness of 0.85 mm, except that 20 parts by mass of an alcohol-modified branched imide resin (trade name: ELG-1302 (acid value: 160 mgKOH/g)) was used instead of 45 parts by mass of the branched imide resin, 5 parts by mass of methyltributylphosphonium dimethyl phosphate (trade name: PX-4MP (produced by Nippon Chemical Industrial Co., Ltd.)) was used as a phosphorus curing accelerator, and 20 parts by mass of a 1,2-epoxy-4-(2-oxiranyl)cyclohexane adduct of 2,2-bis(hydroxymethyl)-1-butanol (trade name: EHPE-3150 (produced by Daicel Corporation)) was further used as an epoxy resin.

### (Example 4)

The same manner as in Example 1 was performed to provide a copper-clad laminate having a thickness of 0.85 mm, except that 20 parts by mass of an alcohol-modified branched imide resin (trade name: ELG-1302 (acid value: 160 mgKOH/g)) was used instead of 45 parts by mass of the branched imide resin, 5 parts by mass of methyltributylphosphonium dimethyl phosphate (trade name: PX-4MP (produced by Nippon Chemical Industrial Co., Ltd.)) was further used as a phosphorus curing accelerator, 20 parts by mass of a 1,2-epoxy-4- (2-oxiranyl)cyclohexane adduct of 2,2-bis(hydroxymethyl)-1-butanol (trade name: EHPE-3150 (produced by Daicel Corporation)) was further used as an epoxy resin, and 5 parts by mass of diallyl monoglycidyl isocyanate (trade name: DA-MGIC (produced by Shikoku Chemicals Corporation)) was further used as an epoxy monomer.

### (Comparative Example 1)

The same manner as in Example 1 was performed to provide a copper-clad laminate having a thickness of 0.85 mm, except that the content of the aliphatic epoxy-modified silicone compound was changed from 55 parts by mass to 58 parts by mass, the branched imide resin was not used, and 42 parts by mass of a cyanate ester compound (trade name: CA210, produced by Mitsubishi Gas Chemical Company, Inc.) was further used.

### (Comparative Example 2)

The same manner as in Example 1 was performed to provide a copper-clad laminate having a thickness of 0.85 mm, except that the content of the aliphatic epoxy-modified silicone compound was changed from 55 parts by mass to 78 parts by mass, the branched imide resin was not used, and 22 parts by mass of a phenol compound (trade name: TD2090, produced by Dic Corporation) was further used.

### (Comparative Example 3)

The same manner as in Example 1 was performed to provide a copper-clad laminate having a thickness of 0.85 mm, except that the content of the aliphatic epoxy-modified silicone compound was changed from 55 parts by mass to 90 parts by mass, the branched imide resin was not used, and 10 parts by mass of an acid anhydride (trade name: H-TMAn, produced by Mitsubishi Gas Chemical Company, Inc.) was further used.

Each of the resulting copper-clad laminates was used to evaluate the reflectance, the reflectance after heating, the reflectance after heating and light treatment, the peel strength, the heat resistance, and the solder heat resistance after moisture absorption.

### (Measurement methods)

### 1) Reflectance

Five sheets obtained by cutting each of the copper-clad laminates to a rectangle having a size of 50 x 50 mm by a dicing saw were prepared, and the copper foils on the surfaces thereof were removed by etching to provide measurement samples. These measurement samples were subjected to measurement of the reflectance at 457 nm using a spectrophotometer (manufactured by Konica Minolta Inc., trade name: CM3610d) according to JIS Z-8722, and the arithmetic average value of the five samples was determined.

### 2) Reflectance after heating

Each of the samples obtained in 1) above was subjected to a heating treatment by a hot air dryer at 180°C for 24 hours. Thereafter, the reflectance was measured in the same manner as in the above measurement of the reflectance, and the arithmetic average value of the five samples was determined.

### 3) Reflectance after heating and light irradiation

Each of the samples obtained in 1) above was placed on a hot plate at 180°C, and irradiated with light using a weather meter and dryer (trade name: SUV-F11, manufactured by Iwasaki Electric Co., Ltd.) in the condition of an ultraviolet (wavelength: 295 to 450 nm) irradiation intensity of 100 mW/cm² with heating for 24 hours. Thereafter, the reflectance was measured in the same manner as in the above measurement of the reflectance, and the arithmetic average value of the five samples was determined.

### 4) Peel strength

Five sheets obtained by cutting each of the copper-clad laminates to a rectangle having a size of 10 x 100 mm by a dicing saw were prepared, and measurement samples whose copper foil on the surfaces remained were obtained. These measurement samples were subjected to measurement of the peel strength of the copper foil using Autograph (manufactured by Shimadzu Corporation, trade name: AG-IS), and the arithmetic average value of the five samples was determined.

### 5) Heat resistance

Three sheets obtained by cutting each of the copper-clad laminates to a rectangle having a size of 50 x 50 mm by a dicing saw were prepared, and measurement samples whose copper foil on the surfaces remained were obtained. These measurement samples were immersed in a solder tank at 288°C for 30 minutes, and then the change in outer appearance thereof was visually observed. The number of sheets, in which the occurrence of swelling was observed, of the three sheets was counted. A case where the occurrence of swelling was not observed in any sheet was rated as "A", and a case where the occurrence of swelling was observed in one or more sheets was rated as "B".

### 6) Solder heat resistance in moisture absorption

Three sheets obtained by cutting each of the copper-clad laminates to a rectangle having a size of 50 x 50 mm by a dicing saw were prepared, and the halves of the copper foil on the surfaces thereof were removed by etching to provide measurement samples. These measurement samples were subjected to moisture absorption at PCT (120°C/2 atm) for 3 hours and further immersed in a solder tank at 260°C for 1 minute, and then the change in outer appearance thereof was visually observed. The number of sheets, in which the occurrence of swelling was observed, of the three sheets was counted. A case where the occurrence of swelling was not observed in any sheet was rated as "A", and a case where the occurrence of swelling was observed in one or more sheets was rated as "B".

The evaluation results are shown in Tables 1 and 2.

**[Table 1]**

| | | Example 1 | Example 2 | Example 3 | Example 4 |
|---|---|---|---|---|---|
| Characteristics of copper foil-clad laminate | Reflectance (%) | 91 | 90 | 89 | 88 |
| | Reflectance after heating (%) | 81 | 80 | 79 | 79 |
| | Reflectance after heating and light irradiation (%) | 75 | 75 | 75 | 75 |
| | Peel strength (gf/cm) | 700 | 650 | 650 | 750 |
| | Heat resistance | A | A | A | A |
| | Solder heat resistance in moisture absorption | A | A | A | A |

**[Table 2]**

| | | Comparative Example 1 | Comparative Example 2 | Comparative Example 3 |
|---|---|---|---|---|
| Characteristics of copper foil-clad laminate | Reflectance (%) | 82 | 76 | 90 |
| | Reflectance after heating (%) | 58 | 24 | 79 |
| | Reflectance after heating and light irradiation (%) | 42 | 22 | 74 |
| | Peel strength (gf/cm) | 600 | 590 | 290 |
| | Heat resistance | B | A | B |
| | Solder heat resistance in moisture absorption | B | A | B |

The present application is based on Japanese Patent Application (Japanese Patent Application No. 2012-180496) filed on August 16, 2012, and the content thereof is herein incorporated by reference.

### Industrial Applicability

A printed-wiring board in which the resin sheet and the like of the present invention are used is high in light reflectance, exhibits a small reduction in light reflectance due to heating treatment and light irradiation treatment and is excellent in heat resistance, and thus is suitable for a printed-wiring board and the like, particularly an LED-mounting printed-wiring board and the like and is extremely high in industrial applicability.

## Claims

1. A resin sheet comprising a layer comprising a resin composition comprising an aliphatic epoxy-modified silicone compound (A), a branched imide resin having an isocyanurate group and a carboxyl group (B), titanium dioxide (C) and a wetting and dispersing agent (D).

2. The resin sheet according to claim 1, wherein the branched imide resin (B) comprises a modified branched imide resin obtained by reacting one or more compounds selected from the group consisting of an epoxy compound, an alcohol compound and an amine compound with a branched imide resin having an isocyanurate group and a carboxyl group.

3. The resin sheet according to claim 1 or 2, wherein an acid value of the branched imide resin (B) is 10 to 200 mgKOH/g.

4. The resin sheet according to any one of claims 1 to 3, wherein an acid value of the wetting and dispersing agent (D) is 20 to 200 mgKOH/g.

5. The resin sheet according to any one of claims 1 to 4, wherein the resin composition further comprises a phosphorus curing accelerator (E).

6. The resin sheet according to any one of claims 1 to 5, wherein the resin composition further comprises an epoxy monomer having one or more epoxy rings (F) other than the aliphatic epoxy-modified silicone compound (A).

7. The resin sheet according to any one of claims 1 to 6, wherein a content of the aliphatic epoxy-modified silicone compound (A) contained in the resin composition is 20 to 80 parts by mass based on 100 parts by mass of the total of the aliphatic epoxy-modified silicone compound (A) and the branched imide resin (B).

8. The resin sheet according to any one of claims 1 to 7, wherein a content of the titanium dioxide (C) contained in the resin composition is 10 to 300 parts by mass based on 100 parts by mass of the total of the aliphatic epoxy-modified silicone compound (A) and the branched imide resin (B).

9. The resin sheet according to any one of claims 1 to 8, wherein the titanium dioxide (C) is subjected to a surface treatment with one or more oxides selected from the group consisting of SiO₂, Al₂O₃, ZrO₂ and ZnO, and comprises 0.5 to 15 parts by mass of the oxides based on 100 parts by mass of the total amount of the titanium dioxide subjected to the surface treatment.

10. The resin sheet according to any one of claims 1 to 9, wherein a content of the wetting and dispersing agent (D) contained in the resin composition is 0.05 to 10 parts by mass based on 100 parts by mass of the total of the aliphatic epoxy-modified silicone compound (A) and the branched imide resin (B).

11. The resin sheet according to any one of claims 1 to 10, wherein the resin sheet is one or more selected from the group consisting of an insulating resin sheet and a white resin sheet.

12. A support with a resin layer, comprising a support and the resin sheet according to any one of claims 1 to 11 provided on the support.

13. The support with a resin layer according to claim 12, wherein the support is one or more selected from the group consisting of a film comprising one or more resins selected from the group consisting of polyvinyl chloride, polyvinylidene chloride, polybutene, polybutadiene, polyurethane, an ethylene-vinyl acetate copolymer, polyethylene terephthalate, polyethylene, polypropylene, an ethylene-propylene copolymer, polymethylpentene and polybutylene terephthalate, aluminum foil, and copper foil.

14. A laminate comprising the resin sheet according to any one of claims 1 to 11 and a metal layer or a resin layer provided on the resin sheet.

15. A metal foil-clad laminate comprising the resin sheet according to any one of claims 1 to 11 and metal foil provided on the resin sheet.

## Patentansprüche

1. Harzfolie, die eine Schicht umfasst, die eine Harzzusammensetzung umfasst, die eine aliphatische Epoxid-modifizierte Silikonverbindung (A), ein verzweigtes Imidharz mit einer Isocyanuratgruppe und einer Carboxylgruppe (B), Titandioxid (C) und ein Benetzungs- und Dispergiermittel (D) umfasst.

2. Harzfolie gemäß Anspruch 1, wobei das verzweigte Imidharz (B) ein modifiziertes verzweigtes Imidharz umfasst, erhalten durch Umsetzen einer oder mehrerer Verbindungen ausgewählt aus der Gruppe, die aus einer Epoxidverbindung, einer Alkoholverbindung und einer Aminverbindung besteht, mit einem verzweigten Imidharz, das eine Isocyanuratgruppe und eine Carboxylgruppe aufweist.

3. Harzfolie gemäß Anspruch 1 oder 2, wobei die Säurezahl des verzweigten Imidharzes (B) 10 bis 200 mgKOH/g beträgt.

4. Harzfolie gemäß einem der Ansprüche 1 bis 3, wobei die Säurezahl des Benetzungs- und Dispergierungsmittels (D) 20 bis 200 mgKOH/g beträgt.

5. Harzfolie gemäß einem der Ansprüche 1 bis 4, wobei die Harzzusammensetzung zusätzlich einen Phosphor-Härtungsbeschleuniger (E) umfasst.

6. Harzfolie gemäß einem der Ansprüche 1 bis 5, wobei die Harzzusammensetzung zusätzlich ein Epoxidmonomer, das ein anderes als die aliphatische Epoxid-modifizierte Silikonverbindung (A) ist, mit einem oder mehreren Epoxidringen (F) umfasst.

7. Harzfolie gemäß einem der Ansprüche 1 bis 6, wobei der Gehalt der aliphatischen Epoxid-modifizierten Silikonverbindung (A), die in der Harzzusammensetzung enthalten ist, 20 bis 80 Massenteile bezogen auf 100 Massenteile der Gesamtmenge an aliphatischer Epoxid-modifizierter Silikonverbindung (A) und verzweigtem Imidharz (B) beträgt.

8. Harzfolie gemäß einem der Ansprüche 1 bis 7, wobei der Gehalt des Titandioxids (C), das in der Harzzusammensetzung enthalten ist, 10 bis 300 Massenteile bezogen auf 100 Massenteile der Gesamtmenge an aliphatischer Epoxid-modifizierter Silikonverbindung (A) und verzweigtem Imidharz (B) beträgt.

9. Harzfolie gemäß einem der Ansprüche 1 bis 8, wobei das Titandioxid (C) einer Oberflächenbehandlung mit einem oder mehreren Oxiden ausgewählt aus der Gruppe, die aus SiO₂, Al₂O₃, ZrO₂ und ZnO besteht, unterzogen wird und 0,5 bis 15 Massenteile der Oxide bezogen auf 100 Massenteile der Gesamtmenge an Titandioxid, das der Oberflächenbehandlung unterzogen wird, umfasst.

10. Harzfolie gemäß einem der Ansprüche 1 bis 9, wobei der Gehalt des Benetzungs- und Dispergiermittels (D), das in der Harzzusammensetzung enthalten ist, 0,05 bis 10 Massenteile bezogen auf 100 Massenteile der Gesamtmenge an aliphatischer Epoxid-modifizierter Silikonverbindung (A) und verzweigtem Imidharz (B) beträgt.

11. Harzfolie gemäß einem der Ansprüche 1 bis 10, wobei die Harzfolie eine oder mehrere ausgewählt aus der Gruppe ist, die aus einer isolierenden Harzfolie und einer weißen Harzfolie besteht.

12. Träger mit einer Harzschicht, umfassend einen Träger und die Harzfolie gemäß einem der Ansprüche 1 bis 11, die auf dem Träger bereitgestellt ist.

13. Träger mit einer Harzschicht gemäß Anspruch 12, wobei der Träger einer oder mehrere ist, ausgewählt aus der Gruppe bestehend aus einer Folie, die ein oder mehrere Harze ausgewählt aus der Gruppe umfasst, die aus Polyvinylchlorid, Polyvinylidenchlorid, Polybuten, Polybutadien, Polyurethan, einem Ethylen-Vinylacetat-Copolymer, Polyethylenterephthalat, Polyethylen, Polypropylen, einem Ethylen-Propylen-Copolymer, Polymetyhlpenten und Polybutylenterephthalat besteht, Aluminiumfolie und Kupferfolie.

14. Laminat, das die Harzfolie gemäß einem der Ansprüche 1 bis 11 und eine Metallschicht oder eine Harzschicht, die auf der Harzfolie bereitgestellt sind, umfasst.

15. Metallfolien-kaschiertes Laminat, das die Harzfolie gemäß einem der Ansprüche 1 bis 11 und eine Metallfolie, die auf die Harzfolie bereitgestellt ist, umfasst.

## Revendications

1. Feuille de résine comprenant une couche comprenant une composition de résine comprenant un composé de silicone modifié par époxy aliphatique (A), une résine imide ramifiée présentant un groupe isocyanurate et un groupe carboxyle (B), du dioxyde de titane (C) et un agent mouillant et dispersant (D).

2. Feuille de résine selon la revendication 1, dans laquelle la résine imide ramifiée (B) comporte une résine imide ramifiée modifiée obtenue par réaction d'un ou plusieurs composés choisis parmi le groupe comprenant un composé époxy, un composé alcool et un composé amine avec une résine imide ramifiée présentant un groupe isocyanurate et un groupe carboxyle.

3. Feuille de résine selon la revendication 1 ou 2, dans laquelle un indice d'acide de la résine imide ramifiée (B) est compris entre 10 et 200 mgKOH/g.

4. Feuille de résine selon l'une des revendications 1 à 3, dans laquelle un indice d'acide de l'agent mouillant et dispersant (D) est compris entre 20 et 200 mgKOH/g.

5. Feuille de résine selon l'une des revendications 1 à 4, dans laquelle la composition de résine comporte en outre un accélérateur de durcissement au phosphore (E).

6. Feuille de résine selon l'une des revendications 1 à 5, dans laquelle la composition de résine comporte en outre un monomère époxy présentant un ou plusieurs cycles époxy (F) autre(s) que le composé de silicone modifié par époxy aliphatique (A).

7. Feuille de résine selon l'une des revendications 1 à 6, dans laquelle une teneur en composé de silicone modifié par époxy aliphatique (A) contenu dans la composition de résine est comprise entre 20 et 80 parts en masse sur la base de 100 parts en masse du total du composé de silicone modifié par époxy aliphatique (A) et de la résine imide ramifiée (B).

8. Feuille de résine selon l'une des revendications 1 à 7, dans laquelle une teneur en dioxyde de titane (C) contenu dans la composition de résine est comprise entre 10 et 300 parts en masse sur la base de 100 parts en masse du total du composé de silicone modifié par époxy aliphatique (A) et de la résine imide ramifiée (B).

9. Feuille de résine selon l'une des revendications 1 à 8, dans laquelle le dioxyde de titane (C) est sujet à un traitement de surface avec un ou plusieurs oxydes choisis parmi le groupe comprenant du SiO₂, AL₂O₃, ZrO₂ et ZnO, et comporte entre 0,5 et 15 parts en masse d'oxydes sur la base de 100 parts en masse de la quantité totale de dioxyde de titane sujet au traitement de surface.

10. Feuille de résine selon l'une des revendications 1 à 9, dans laquelle une teneur en agent mouillant et dispersant (D) contenu dans la composition de résine est comprise entre 0,05 et 10 parts en masse sur la base de 100 parts en masse du total du composé de silicone modifié par époxy aliphatique (A) et de la résine imide ramifiée (B).

11. Feuille de résine selon l'une des revendications 1 à 10, dans laquelle la feuille de résine est une ou plusieurs parmi le groupe comprenant une feuille de résine d'isolation et une feuille de résine blanche.

12. Support avec une couche de résine, comprenant un support et la feuille de résine selon l'une des revendications 1 à 11 agencée sur le support.

13. Support avec une couche de résine selon la revendication 12, dans lequel le support est un ou plusieurs choisis parmi le groupe comportant un film comprenant une ou plusieurs résines choisies parmi le groupe comprenant du chlorure de polyvinyle, du chlorure de polyvinylidène, du polybutène, du polybutadiène, du polyuréthane, un copolymère d'éthylène-acétate de vinyle, du polyéthylène téréphtalate, du polyéthylène, du polypropylène, un copolymère d'éthylène-propylène, du polyméthylpentène et du polybutylène téréphtalate, une feuille d'aluminium et une feuille de cuivre.

14. Stratifié comprenant la feuille de résine selon l'une des revendications 1 à 11 et une couche métallique ou une couche de résine agencée sur la feuille de résine.

15. Stratifié recouvert d'une feuille de métal comprenant la feuille de résine selon l'une des revendications 1 à 11 et une feuille métallique agencée sur la feuille de résine.
